# EUROPEAN PATENT SPECIFICATION

(11) **EP 4 657 099 B1**
(45) Date of publication and mention of the grant of the patent: **28.10.2026**
(21) Application number: 25179401.2
(22) Date of filing: 28.05.2025
(51) Int. Cl.: G01R 31/389

(54) **DETECTION CIRCUIT AND METHOD FOR DETECTING INTERNAL RESISTANCE OF BATTERY UNIT**
DETEKTIONSSCHALTUNG UND VERFAHREN ZUR DETEKTION DES INNENWIDERSTANDES EINER BATTERIEEINHEIT
CIRCUIT DE DÉTECTION ET PROCÉDÉ DE DÉTECTION DE RÉSISTANCE INTERNE D'UNITÉ DE BATTERIE

(30) Priority: 31.05.2024 CN 202410703389
(43) Date of publication of application: 03.12.2025
(73) Proprietor: Joulwatt Technology Co., Ltd., Hangzhou, Zhejiang Province 310030 (CN)
(72) Inventor: Du, Hongxia, Hangzhou Zhejiang Province, 310030 (CN)
(74) Representative: Bals & Vogel Patentanwälte PartGmbB

(56) References cited:
- WO-A1-2023/189370
- US-A1- 2016 202 326
- US-A1- 2017 285 108

## Description

### CROSS-REFERENCE TO PRIOR APPLICATIONS

The present application claims priority to Chinese Patent Application No. 202410703389.X, filed on May 31, 2024, entitled "DETECTION CIRCUIT AND METHOD FOR DETECTING INTERNAL RESISTANCE OF BATTERY UNIT".

### TECHNICAL FIELD

The present disclosure relates to a field of battery technology, in particular to a detection circuit and a method for detecting an internal resistance of a battery unit.

### BACKGROUND

In the prior art, batteries are often used to supply power for electronic devices, and it is usually necessary to measure an internal resistance of the battery. The internal resistance of the battery is an important parameter for evaluating the lifetime and health status of the battery. In the prior art, methods for measuring battery internal resistance often require a DC-blocking filter capacitor. Through this capacitor, the disturbance amount of the battery voltage can be obtained, and based on a ratio of this voltage disturbance amount to the discharge current, a corresponding battery internal resistance can be determined. However, a frequency band for measuring battery internal resistance is generally wide, and the DC-blocking filter capacitor is usually set to be large, which results in a large occupied area, making it unfavorable for miniaturization and integration. Patent document WO2023189370 discloses a circuit for determining internal impedance of a battery, wherein the battery comprises a plurality of sub-batteries. The circuit comprises a current source and a resistor used as a current detector, and a voltage divider connected to a calculator used to determine a terminal voltage across the battery. The voltage is determined by averaging the voltage measured across each voltage divider resistor. Internal impedance of the battery is determined by the calculator based on the measured current and the determined voltage. Therefore, it is necessary to improve the existing technology to solve the problems existing in the prior art.

### SUMMARY OF THE DISCLOSURE

To solve the above technical problems, the present disclosure provides a detection circuit and a method for detecting an internal resistance of a battery unit.

According to a first aspect of the present invention, a battery unit internal resistance detection circuit is provided, wherein the battery unit comprises at least one sub-battery connected in series, where N represents a quantity of the at least one sub-battery and is a natural number greater than or equal to 1; wherein the detection circuit comprises:
first to fourth ports, wherein a positive terminal of the battery unit is coupled to the first port, and a negative terminal of the battery unit is coupled to the second port; the third port is coupled to a positive terminal of one of the at least one sub-battery, and the fourth port is coupled to a negative terminal of the one of the at least one sub-battery;
a discharge current generation circuit and a first switch, wherein the discharge current generation circuit and the first switch are serially arranged in a branch between the first port and the second port, the discharge current generation circuit is used to generate a discharge current, and by controlling an operating frequency of the first switch, a current disturbance occurs in the battery unit;
a first analog-to-digital converter, which, based on the current disturbance, converts a difference between a voltage at the third port and a reference voltage into a first digital signal, the reference voltage being generated by a reference voltage generation circuit;
a logic control circuit, wherein the logic control circuit is configured to control the operating frequency of the first switch, and obtain an internal resistance of the sub-battery coupled between the third port and the fourth port in accordance with the first digital signal, and the discharge current or a second digital signal converted from a current sampling signal of the discharge current; or, the logic control circuit is configured to send the first digital signal, and the discharge current signal or the second digital signal converted from the current sampling signal of the discharge current, to a processor which is configured to process the signals to obtain the internal resistance of the sub-battery coupled between the third port and the fourth port.

Optionally, the detection circuit further comprises a current sampling circuit, used to sample the discharge current to obtain the current sampling signal, and the first analog-to-digital converter is further used to convert the current sampling signal into the second digital signal.

Optionally, the reference voltage generation circuit is a digital-to-analog converter, which is used to convert a received digital signal into the reference voltage.

Optionally, the received digital signal is either a digital signal output by the logic control circuit, or a digital signal which is converted by the first analog-to-digital converter from a maximum voltage detected at the third port when the first switch is operated in off state.

Optionally, when the logic control circuit controls the first switch to operate at a predetermined frequency, the reference voltage is an average value of a voltage at the third port.

Optionally, the reference voltage generation circuit comprises a second analog-to-digital converter and a digital-to-analog converter; an input terminal of the second analog-to-digital converter is coupled to the third port, and when the logic control circuit controls the first switch to operate at the predetermined frequency: the second analog-to-digital converter performs analog-to-digital conversion and averaging operation on the voltage at the third port in at least one consecutive switching cycle and then outputs a third digital signal; or the second analog-to-digital converter outputs a third digital signal every time when a timing reaches a predetermined timing period, wherein the second analog-to-digital converter performs analog-to-digital conversion and averaging operation on the voltage at the third port within the predetermined timing period and then outputs the third digital signal; and the digital-to-analog converter is configured to convert the third digital signal into the reference voltage.

Optionally, the detection circuit further comprises a second switch and a third switch; the second switch is coupled in a branch between the reference voltage generation circuit and the first analog-to-digital converter; the third switch is coupled in a branch between the third port and the first analog-to-digital converter; the logic control circuit is configured to control on and off states of the second switch and the third switch;
when the second switch and the third switch are operated in on state, the first analog-to-digital converter converts the difference between the voltage at the third port and the reference voltage into the first digital signal.

Optionally, the current sampling circuit is a resistor, which is serially connected in a branch where the discharge current generation circuit is located; the current sampling signal is obtained in accordance with a voltage across the resistor;
the detection circuit further comprises a fourth switch and a fifth switch; the fourth switch is coupled in a branch between a first end of the resistor and the first analog-to-digital converter; the fifth switch is coupled in a branch between a second end of the resistor and the first analog-to-digital converter; the logic control circuit is configured to control on and off states of the fourth switch and the fifth switch;
when the fourth switch and the fifth switch are operated in on state, the first analog-to-digital converter converts the current sampling signal into the second digital signal.

Optionally, when N is greater than 1, the detection circuit further comprises a multiplexer, which is coupled to positive and negative terminals of the N sub-batteries; the multiplexer is used to select and couple a positive terminal of the i-th sub-battery of the N sub-batteries with the third port in a time-sharing manner, and to couple a negative terminal of the i-th sub-battery with the fourth port, where 1≤i≤N.

Optionally, the voltage across the sub-battery that is coupled between the third port and the fourth port is obtained using a Kelvin connection approach.

Optionally, the detection circuit is integrated inside a single chip; or, components of the detection circuit, except for the processor, is integrated inside a single chip.

The present invention also provides a method for detecting an internal resistance of a battery unit, wherein the battery unit comprises at least one sub-battery connected in series, where N represents a quantity of the at least one sub-battery and is a natural number greater than or equal to 1; wherein the method comprises:
arranging a discharge current generation circuit and a first switch in series in a branch between a positive terminal and a negative terminal of the battery unit; controlling an operating frequency of the first switch, to allow a current disturbance to occur in the battery unit;
coupling a positive terminal of one of the at least one sub-battery to the third port, and coupling the fourth port to a negative terminal of the one of the at least one sub-battery; based on the current disturbance, converting a difference between a voltage at the third port and a reference voltage into a first digital signal through a first analog-to-digital converter;
in accordance with the first digital signal, and the discharge current or a second digital signal converted from a current sampling signal of the discharge current, obtaining an internal resistance of the sub-battery coupled between the third port and the fourth port; or, sending the first digital signal, and the discharge current signal or the second digital signal converted from the current sampling signal of the discharge current, to a processor which is configured to process the signals to obtain the internal resistance of the sub-battery coupled between the third port and the fourth port.

Optionally, the current sampling signal is obtained by sampling the discharge current, and is converted into the second digital signal by the first analog-to-digital converter.

Optionally, the reference voltage is obtained by conversion through a digital-to-analog converter, which is used to convert a received digital signal into the reference voltage.

Optionally, the received digital signal is either a digital signal output by the logic control circuit, or a digital signal converted by the first analog-to-digital converter from a maximum voltage at the third port when the first switch is operated in off state.

Optionally, when the logic control circuit controls the first switch to operate at a predetermined frequency, the reference voltage is an average value of a voltage at the third port.

Optionally, when N is greater than 1, positive and negative terminals of the N sub-batteries are coupled to a multiplexer; the multiplexer is used to select and couple a positive terminal of an i-th sub-battery of the N sub-batteries with the third port in a time-sharing manner, and to couple a negative terminal of the i-th sub-battery with the fourth port, where 1≤i≤N.

Optionally, the voltage across the sub-battery that is coupled between the third port and the fourth port is obtained using a Kelvin connection approach.

The present disclosure at least has following advantages:
the detection circuit and the method for detecting the internal resistance of the battery unit provided by the present disclosure, controls the operating frequency of the first switch through the logic control circuit, so that a disturbance current at a certain frequency occurs in the battery unit, thereby causing a certain disturbance on the voltage of the battery unit. The disturbance amount of the voltage (or the difference between the voltage at the third port and the reference voltage) is converted into the first digital signal by the first analog-to-digital converter, and the internal resistance of the corresponding sub-battery is detected based on the first digital signal and the discharge current. According to the present disclosure, by sending the difference between the voltage at the third port VBAT and the reference voltage VREF to the first analog-to-digital converter for conversion, compared to a solution which directly sends the voltage VBAT at the third port to the first analog-to-digital converter for conversion, the voltage range to be quantified by the first analog-to-digital converter is smaller, which can improve resolution, reduce quantization error, and enhance detection accuracy. Moreover, this approach avoids the use of a DC-blocking filter capacitor, saving space and facilitating integration and miniaturization.

Furthermore, a current sampling circuit can be arranged to sample a magnitude of the discharge current, and the current sampling signal is converted into the second digital signal by the first analog-to-digital converter. Based on the first digital signal and the second digital signal, the internal resistance of the corresponding sub-battery is detected. With the above setup, since both the first digital signal and the second digital signal are converted by the first analog-to-digital converter, gain errors caused by different analog-to-digital converters can be avoided, improving the accuracy of battery internal resistance detection. Moreover, under the same detection accuracy, the discharge current can be set to a reduced magnitude through the solution provided according to the present disclosure, thereby reducing system power consumption.

Furthermore, the reference voltage according to the present disclosure can be converted by a digital-to-analog converter, where the digital signal can be a digital signal output by the logic control circuit, or a digital signal converted by the first analog-to-digital converter from a maximum value of the voltage of the battery. The reference voltage can also be the average value of the voltage of the battery. That is, the magnitude of the reference voltage according to the present disclosure can be adjusted according to the corresponding digital signal, enhancing flexibility.

It should be noted that the above general description and the following detailed description are merely exemplary and explanatory and do not limit the present invention. The scope of the invention is defined by the appended claims.

### BRIEF DESCRIPTION OF THE DRAWINGS

FIG. 1 shows a schematic diagram of a detection circuit for detecting an internal resistance of a battery unit according to an embodiment of the present disclosure;
FIG. 2 shows an operating waveform diagram of a detection circuit for detecting an internal resistance of a battery unit according to an embodiment of the present disclosure;
FIG. 3 shows a schematic diagram of a reference voltage generation circuit according to an embodiment of the present disclosure;
FIG. 4 shows a schematic diagram of a reference voltage generation circuit according to another embodiment of the present disclosure;
FIG. 5 shows a schematic diagram of a detection circuit for detecting an internal resistance of a battery unit according to another embodiment of the present disclosure;
FIG. 6 shows a schematic diagram of a detection circuit for detecting an internal resistance of a battery unit according to another embodiment of the present disclosure.

### DETAILED DESCRIPTION

To facilitate understanding of the present disclosure, a more comprehensive description of the present disclosure will be provided below with reference to the relevant drawings. The preferred embodiments of the present disclosure are given in the drawings. However, the present disclosure can be implemented in different forms and is not limited to the embodiments described herein. On the contrary, the provision of these embodiments is to make the disclosure of the present disclosure more thorough and comprehensive.

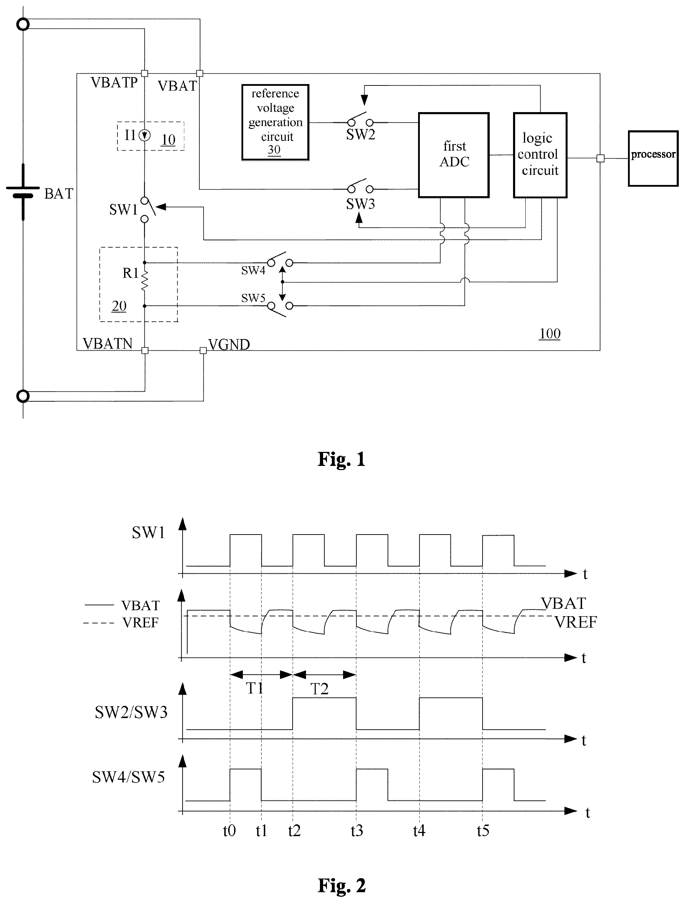

FIG. 1 shows a schematic diagram of a detection circuit for detecting an internal resistance of a battery unit provided according to an embodiment of the present disclosure, including a battery unit BAT, wherein the battery unit includes at least one sub-battery connected in series, where N represents a quantity of the at least one sub-battery and is a natural number greater than or equal to 1. In FIG. 1, N is illustrated as equal to 1 (i.e., the battery unit BAT contains one sub-battery). It should be noted that when N is equal to 1, the battery unit BAT may also represent multiple parallel-connected sub-batteries. The detection circuit further includes a discharge current generation circuit 10, a first switch SW1, a reference voltage generation circuit 30, a first analog-to-digital converter (ADC), and a logic control circuit. The detection circuit also has first to fourth ports, a positive terminal of the battery unit BAT is coupled to the first port VBATP, and a negative terminal of the battery unit BAT is coupled to the second port VBATN. The discharge current generation circuit 10 is arranged in a branch between the first port VBATP and the second port VBATN to generate a discharge current between the first port VBATP and the second port VBATN. The first switch SW1 is connected in series in the branch where the discharge current generation circuit 10 is located, and on and off states of the first switch SW1 are controlled by the logic control circuit, i.e., the logic control circuit is configured to control an operating frequency of the first switch. By controlling the on and off states of the first switch, current disturbance at a certain frequency can be generated on the battery unit BAT; this current disturbance will further cause a certain fluctuation on the voltage of the battery unit BAT. The positive terminal of the battery unit BAT is coupled to the third port VBAT, the negative terminal of the battery unit BAT is connected to the fourth port VGND, and the voltage of the battery unit BAT is detected through the third port VBAT. The first analog-to-digital converter is used to convert a difference between the voltage at the third port VBAT and the reference voltage VREF (this difference can represent the voltage fluctuation amount on the battery unit) into a first digital signal; wherein the reference voltage is generated by the reference voltage generation circuit 30. In the first embodiment of the present disclosure, the logic control circuit can obtain the internal resistance of the battery unit VBAT based on the first digital signal and the magnitude of the discharge current, or, as shown in FIG. 1, the detection circuit can also be equipped with a processor, which processes the first digital signal and the discharge current to obtain the internal resistance of the battery unit BAT. By sending the difference between the voltage at the third port VBAT and the reference voltage VREF to the first analog-to-digital converter for conversion, compared to a solution which directly sends the voltage at the third port VBAT to the first analog-to-digital converter for conversion, the voltage range to be quantified by the first analog-to-digital converter is smaller, which can improve resolution, reduce quantization error, and enhance detection accuracy. Moreover, this approach avoids the use of a DC-blocking filter capacitor, saving space and facilitating integration and miniaturization.

However, the solution as mentioned above directly uses the discharge current to calculate the internal resistance of the battery unit, and requires high accuracy on designing the discharge current. To address this issue, further, as shown in FIG. 1, according to the second embodiment of this document, the detection circuit is also equipped with a current sampling circuit 20, which is arranged in a branch where the discharge current generation circuit is located, used to sample the discharge current to obtain a current sampling signal, and the first analog-to-digital converter is further used to convert the current sampling signal into a second digital signal. In this embodiment, the logic control circuit can obtain an internal resistance of the battery unit VBAT based on the first digital signal and the second digital signal, or, as shown in FIG. 1, the detection circuit can also be equipped with a processor, and the logic control circuit is configured to send the first digital signal and the second digital signal to the processor, which processes the first digital signal and the second digital signal to obtain the internal resistance of the battery unit BAT. In this embodiment, the magnitude of the discharge current is also sampled through the current sampling circuit, a problem that the accuracy of detecting the internal resistance of the battery unit is low when the design accuracy of the discharge current is not high can be avoided, i.e., the detection accuracy of the battery unit can be improved; at the same time, both the first digital signal representing the voltage disturbance and the second digital signal representing the current sampling signal are converted by the first analog-to-digital converter, thus, when calculating the internal resistance of the battery unit based on these two digital signals, gain errors caused by using different analog-to-digital converters can be avoided, further improving the detection accuracy of the internal resistance of the battery unit. Of course, for applications with low requirements on the detection accuracy of the internal resistance of the battery unit, two analog-to-digital converters can also be arranged to perform analog-to-digital conversion on the corresponding voltage and the current sampling signal separately.

As shown in FIG. 1, the discharge current generation circuit 10 is represented by a current source I1, and the specific generation method performed by the current source I1 is not limited in the present disclosure. The resistor R1 can serve as the current sampling circuit 20, and the current sampling signal is obtained based on the voltage across the resistor R1. It should be noted that the current sampling signal in the present disclosure is not limited to a current signal and can also be a voltage signal; of course, other methods can also be used to sample the current. The resistor R1 is also connected in the branch where the discharge current generation circuit is located, and a fourth switch SW4 is arranged between the first end of the resistor R1 and the first analog-to-digital converter; a fifth switch SW5 is arranged between the second end of the resistor R1 and the first analog-to-digital converter, and the on and off states of the fourth switch and the fifth switch are controlled by the logic control circuit. The detection circuit further includes a second switch SW2 and a third switch SW3; the second switch SW2 is connected between the reference voltage generation circuit 30 and the first analog-to-digital converter; the third switch SW3 is connected between the third port VBAT and the first analog-to-digital converter; the on and off states of the second switch and the third switch are also controlled by the logic control circuit. It should be noted that the description of A being connected between B and C in the present disclosure is not limited to a situation where A is directly connected to B and C, but also includes a situation where a component other than A is connected between B and C. By controlling the on and off states of the first to fifth switches, the detection of the internal resistance of the battery unit can be realized.

FIG. 2 shows an operating waveform diagram of the detection circuit. In conjunction with FIG. 2, the principle of the detection circuit in this embodiment is further explained below. Before time t0, the first switch SW1 is in off state. After time t0, the logic control circuit controls the first switch SW1 to operate at a certain frequency (i.e., the first switch SW1 is turned on and off alternately). Between time t0 and time t1, the first switch is controlled to operate in on state, and between time t1 and time t2, the first switch is controlled to operate in off state. The time period between time t0 to time t2 is a switching cycle T, and so on; with the alternating on and off states of the first switch, a disturbance current at a certain frequency is generated on the battery unit BAT, causing the voltage VBAT on the battery unit BAT to change as shown in FIG. 2. In the first switching cycle T1, between time t0 and time t1, the logic control circuit controls the fourth switch SW4 and the fifth switch SW5 to operate in on state. At this time, the first analog-to-digital converter receives the voltage across the resistor R1 and converts the corresponding voltage value into the second digital signal, and the logic control circuit receives this second digital signal; the current flowing through the resistor R1 (i.e., the discharge current I1) is a ratio of this voltage to the resistor R1. In the embodiment shown in FIG. 1, this voltage value is used to represent a corresponding current sampling signal. Between time t1 and time t2, the fourth switch and the fifth switch are controlled to operate in off state. In the second switching cycle T2 (t2-t3), the logic control circuit controls the second switch SW2 and the third switch SW3 to operate in on state. At this time, the first analog-to-digital converter can receive the voltage VBAT across the battery unit and the reference voltage VREF, and convert the difference △V between these two voltages into a first digital signal, and the logic control circuit receives this first digital signal; the logic control circuit processes the first digital signal and the second digital signal to obtain the internal resistance of the battery unit, or, in some other embodiments, the logic control circuit can also send the first digital signal and the second digital signal to the processor, which performs corresponding processing operation to obtain the internal resistance of the battery unit. In another embodiment of this application, a corresponding division circuit can also be arranged before the first analog-to-digital converter to directly obtain the magnitude of the current flowing through the resistor R1, and the first analog-to-digital converter converts this current into the second digital signal. After time t3, the operating process corresponding to the first switching cycle and the second switching cycle can be repeated.

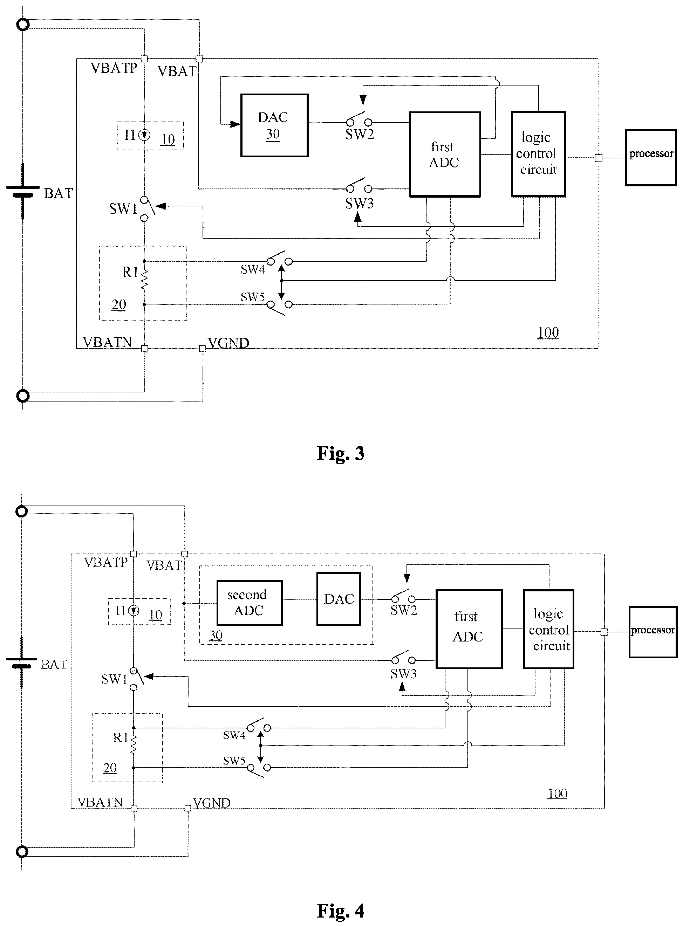

Furthermore, the reference voltage VREF can be generated by a digital-to-analog converter (DAC), which is used to convert the received digital signal into the reference voltage VREF. This digital signal can be provided from the logic control circuit or be generated by other means. For example, FIG. 3 shows an embodiment of a reference voltage generation circuit provided according to an embodiment of the present disclosure. Referring to FIG. 3, the digital signal of the digital-to-analog converter is generated by the first analog-to-digital converter. Specifically, when the first switch SW1 is operated in off state, the third switch SW3 can be turned on. At this time, a maximum value of the voltage VBAT across the battery unit is input to the first analog-to-digital converter, and is converted, by the first analog-to-digital converter, into a corresponding digital signal, which is input to the digital-to-analog converter; specifically, the maximum value of the voltage VBAT can be obtained by arranging a corresponding circuit, which is not provided in detail by the present disclosure; or another branch can be arranged to detect the maximum value of the VBAT voltage, and the present application is not limited to the specific details herein. That is, in this case, the reference voltage VREF corresponds to the maximum value of the voltage VBAT in FIG. 2. In addition, a full-scale range of the first analog-to-digital converter can be switched accordingly to perform analog-to-digital conversion for different needs. Registers, switches, and other modules can also be arranged before or after the digital-to-analog converter to obtain the reference voltage VREF through corresponding modifications. After obtaining the reference voltage VREF, based on the principle of calculating the internal resistance of the battery unit BAT, the detection of the internal resistance of the battery unit BAT can be realized by controlling the on and off states of the first to fifth switches through the logic control circuit.

Furthermore, the reference voltage VREF can be the average value of the voltage VBAT across the battery unit. For example, FIG. 4 shows another embodiment of a reference voltage generation circuit provided according to the present disclosure. In this embodiment, the reference voltage generation circuit 30 includes a second analog-to-digital converter and a digital-to-analog converter; an input terminal of the second analog-to-digital converter is coupled to the third port VBAT; specifically, when the logic control circuit controls the first switch SW1 to operate at a certain frequency, the second analog-to-digital converter can perform analog-to-digital conversion on the voltage at the third port in at least one consecutive switching cycle and calculate the average value to output a third digital signal, or the second analog-to-digital converter can also output the third digital signal every time when a timing reaches a predetermined timing period, which can be set according to actual applications, wherein the second analog-to-digital converter performs analog-to-digital conversion on the voltage at the third port within the predetermined timing period and calculates the average value to output the third digital signal; the digital-to-analog converter converts the third digital signal into the reference voltage VREF. In some other embodiments according to the present disclosure, the reference voltage VREF can also be obtained by limiting the number of sampling conversions performed by the first analog-to-digital converter. In addition, registers, switches, and other modules can be arranged before or after the digital-to-analog converter, i.e., corresponding modifications can be made to this embodiment to obtain the reference voltage VREF. After obtaining the reference voltage VREF, similarly, based on the principle of calculating the internal resistance of the battery unit BAT, the detection of the internal resistance of the battery unit BAT can be realized by controlling the on and off states of the first to fifth switches through the logic control circuit.

It should be noted that the circuit schematic diagrams in FIG. 1, FIG. 3, and FIG. 4 are just some embodiments of this document, and the present disclosure is not limited thereto. Corresponding modifications to achieve same functions are also within the scope of the present application.

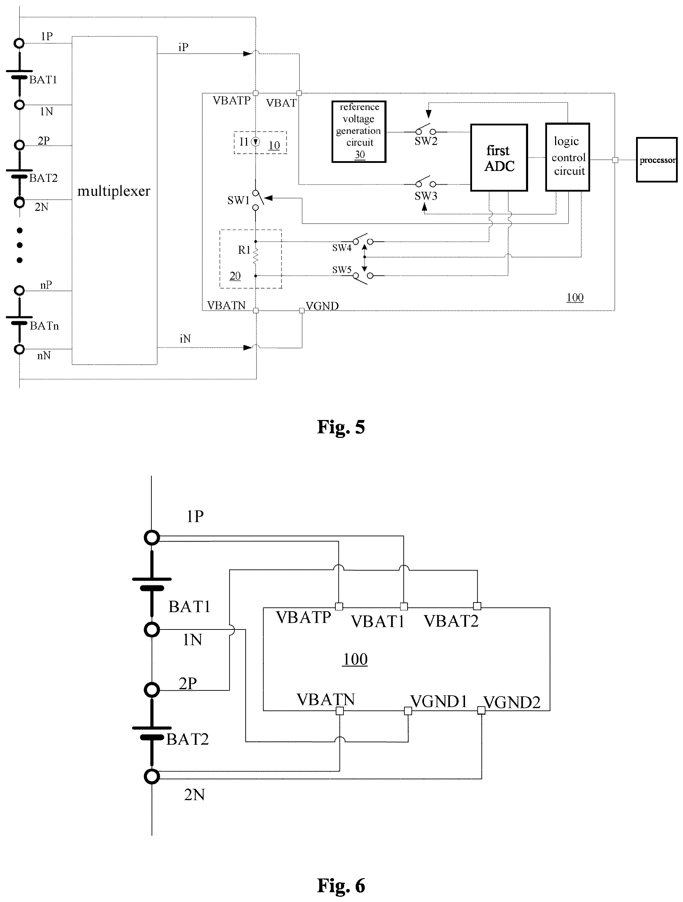

By taking N equal to 1 as an example, the principle of the detection circuit for detecting the internal resistance of the battery unit BAT is described as above. Of course, N can also take a value greater than 1. FIG. 5 shows another embodiment of the detection circuit for detecting the internal resistance of the battery unit provided according to the present disclosure. In this embodiment, N takes a value greater than 1, i.e., the battery unit BAT contains more than one sub-batteries (i.e., sub-batteries BAT1, BAT2...BATn). In this embodiment, the detection circuit further includes a multiplexer, which is used to select and couple a positive terminal of the i-th sub-battery with the third port VBAT in a time-sharing manner, and to couple a negative terminal of the i-th sub-battery with the fourth port VGND, where 1≤i≤N. That is, through the multiplexer, the detection circuit is shared by the N sub-batteries to achieve the detection of the internal resistance of each sub-battery. In one embodiment of this document, the operation of the multiplexer can be controlled by the logic control circuit.

Furthermore, to ensure the accuracy of disturbance voltage measurement, the voltage across the sub-battery coupled between the third port and the fourth port can be obtained using a Kelvin connection approach.

Furthermore, as shown in FIG. 1 and FIG. 3 to FIG. 5, components of the detection circuit for detecting the internal resistance of the battery unit, except for the processor, can be integrated into a single chip 100, and in this case, the logic control circuit can achieve information exchange with the processor through another port. Of course, in some other embodiments, the processor can also be integrated inside the chip 100. In addition, when the multiplexer is arranged, it can also be integrated inside the chip 100. Specific integration manners can be used according to actual applications.

Furthermore, when the battery unit BAT contains more than two sub-batteries (i.e., N is greater than 1), here, taking N equal to 2 as an example, as shown in FIG. 6, the detection circuit is further equipped with a fifth port VBAT2 and a sixth port VGND2, a positive terminal of the first sub-battery BAT1 is coupled to the third port, and a negative terminal of the first sub-battery BAT1 is coupled to the fourth port; a positive terminal of the second sub-battery BAT2 is coupled to the fifth port, and a negative terminal of the second sub-battery BAT2 is coupled to the sixth port. The circuits coupled to the fifth port and the sixth port can provide same functions as the circuits coupled to the third port and the fourth port, which will not be repeatedly described in detail hereto. In this way, the measurement of the voltage disturbance on the first sub-battery BAT1 can be realized through the third port and the fourth port; the measurement of the voltage disturbance on the second sub-battery BAT2 can be realized through the fifth port and the sixth port, thereby achieving the detection of the internal resistances of the corresponding sub-batteries. When N takes other values, a corresponding number of ports can also be arranged to simultaneously achieve the detection of the internal resistances of these N sub-batteries.

Furthermore, when the battery unit BAT contains multiple sub-batteries (e.g., N is greater than 2), as shown in FIG. 5, a multiplexer can be used to perform time-share multiplexing operation on the third to sixth ports to achieve the detection of the internal resistances of two sub-batteries simultaneously.

In addition, a battery pack can be finally formed by K serially-connected battery units BAT, which supply power to electronic devices, where K is a natural number greater than or equal to 1.

In summary, the detection circuit and the method for detecting the internal resistance of the battery unit provided by the present disclosure, controls the operating frequency of the first switch with the logic control circuit, so that a disturbance current at a certain frequency occurs in the battery unit, thereby causing a certain disturbance on the voltage of the battery unit. The disturbance amount of the voltage (or the difference between the voltage at the third port and the reference voltage) is converted into the first digital signal by the first analog-to-digital converter, and the internal resistance of the corresponding sub-battery is detected based on the first digital signal and the discharge current. According to the present disclosure, by sending the difference between the voltage at the third port VBAT and the reference voltage VREF to the first analog-to-digital converter for conversion, compared to a solution which directly sends the voltage VBAT at the third port to the first analog-to-digital converter for conversion, the voltage range to be quantified by the first analog-to-digital converter is smaller, which can improve resolution, reduce quantization error, and enhance detection accuracy. Moreover, this approach avoids the use of a DC-blocking filter capacitor, saving space and facilitating integration and miniaturization.

Furthermore, a current sampling circuit can be arranged to sample the magnitude of the discharge current, and the current sampling signal is converted into the second digital signal by the first analog-to-digital converter. Based on the first digital signal and the second digital signal, the internal resistance of the corresponding sub-battery is detected. With the above setup, since both the first digital signal and the second digital signal are converted by the first analog-to-digital converter, gain errors caused by different analog-to-digital converters can be avoided, improving the accuracy of battery internal resistance detection. Moreover, under the same detection accuracy, the discharge current can be set to a reduced magnitude through the solution provided according to the present disclosure, thereby reducing the system's power consumption.

Furthermore, the reference voltage according to the present disclosure can be converted by a digital-to-analog converter, where the digital signal can be a digital signal output by the logic control circuit, or a digital signal converted by the first analog-to-digital converter from a maximum value of the voltage of the battery. The reference voltage can also be the average value of the voltage of the battery. That is, the magnitude of the reference voltage according to the present disclosure can be adjusted according to the corresponding digital signal, enhancing flexibility.

Finally, it should be noted that: obviously, the above embodiments are merely examples for clearly illustrating the present disclosure and are not limitations on the implementation methods. It should be noted and understood that improvements and modifications of the embodiments described above may be made, within the scope of the appended claims.

## Claims

1. A detection circuit for detecting an internal resistance of a battery unit (BAT), wherein the battery unit comprises a single sub-battery, or two or more sub-batteries connected in series, between a positive terminal (VBATP) of the battery unit and the negative terminal (VBATN) of the battery unit, wherein a quantity of the sub-batteries in the battery unit is N;
wherein the detection circuit comprises:
first to fourth ports, wherein the positive terminal (VBATP) of the battery unit is coupled to the first port, and the negative terminal (VBATN) of the battery unit is coupled to the second port, the third port is coupled to a positive terminal of one of the at least one sub-battery, and the fourth port is coupled to a negative terminal of the one of the at least one sub-battery;
a discharge current generation circuit (10) and a first switch (SW1), wherein the discharge current generation circuit and the first switch are serially arranged in a branch between the first port and the second port, the discharge current generation circuit is used to generate a discharge current (I1), and by controlling an operating frequency of the first switch, a current disturbance occurs in the battery unit;
a first analog-to-digital converter, which, based on the current disturbance, converts a difference between a voltage at the third port and a reference voltage into a first digital signal, the reference voltage being generated by a reference voltage generation circuit (30);
a logic control circuit, wherein the logic control circuit is configured to control the operating frequency of the first switch, and obtain an internal resistance of the sub-battery coupled between the third port and the fourth port in accordance with the first digital signal, and the discharge current or a second digital signal converted from a current sampling signal of the discharge current; or, the logic control circuit is configured to send the first digital signal, and the discharge current signal or the second digital signal converted from the current sampling signal of the discharge current, to a processor which is configured to process the signals to obtain the internal resistance of the sub-battery coupled between the third port and the fourth port.

2. The detection circuit according to claim 1, further comprising a current sampling circuit (20), configured to sample the discharge current to obtain the current sampling signal, and the first analog-to-digital converter is further used to convert the current sampling signal into the second digital signal.

3. The detection circuit according to claim 1, wherein the reference voltage generation circuit is a digital-to-analog converter, which is used to convert a received digital signal into the reference voltage.

4. The detection circuit according to claim 3, wherein the received digital signal is either a digital signal output by the logic control circuit, or a digital signal which is converted by the first analog-to-digital converter from a maximum voltage detected at the third port when the first switch is operated in off state.

5. The detection circuit according to claim 1, wherein when the logic control circuit controls the first switch to operate at a predetermined frequency, the reference voltage is an average value of a voltage at the third port.

6. The detection circuit according to claim 5, wherein the reference voltage generation circuit comprises a second analog-to-digital converter and a digital-to-analog converter; an input terminal of the second analog-to-digital converter is coupled to the third port,
wherein when the logic control circuit controls the first switch to operate at the predetermined frequency:
the second analog-to-digital converter performs analog-to-digital conversion and averaging operation on the voltage at the third port in at least one consecutive switching cycle and then outputs a third digital signal; or
the second analog-to-digital converter outputs a third digital signal every time when a timing reaches a predetermined timing period, wherein the second analog-to-digital converter performs analog-to-digital conversion and averaging operation on the voltage at the third port within the predetermined timing period and then outputs the third digital signal; and
the digital-to-analog converter is configured to convert the third digital signal into the reference voltage.

7. The detection circuit according to claim 1, further comprising a second switch (SW2) and a third switch (SW3),
wherein the second switch is coupled in a branch between the reference voltage generation circuit and the first analog-to-digital converter; the third switch is coupled in a branch between the third port and the first analog-to-digital converter; the logic control circuit is configured to control on and off states of the second switch and the third switch;
wherein when the second switch and the third switch are operated in on state, the first analog-to-digital converter converts the difference between the voltage at the third port and the reference voltage into the first digital signal.

8. The detection circuit according to claim 2, wherein:
the current sampling circuit is a resistor (R1), which is serially connected in a branch where the discharge current generation circuit is located; the current sampling signal is obtained in accordance with a voltage across the resistor;
the detection circuit further comprises a fourth switch (SW4) and a fifth switch (SW5); the fourth switch is coupled in a branch between a first end of the resistor and the first analog-to-digital converter; the fifth switch is coupled in a branch between a second end of the resistor and the first analog-to-digital converter; the logic control circuit is configured to control on and off states of the fourth switch and the fifth switch;
when the fourth switch and the fifth switch are operated in on state, the first analog-to-digital converter converts the current sampling signal into the second digital signal.

9. The detection circuit according to claim 1, wherein,
when N is greater than 1, the detection circuit further comprises a multiplexer, which is coupled to positive and negative terminals of the N sub-batteries; the multiplexer is used to select and couple a positive terminal of an i-th sub-battery of the N sub-batteries with the third port in a time-sharing manner, and to couple a negative terminal of the i-th sub-battery with the fourth port, where 1≤i≤N.

10. The detection circuit according to claim 1, wherein the voltage across the sub-battery that is coupled between the third port and the fourth port is obtained using a Kelvin connection approach.

11. The detection circuit according to any one of claims 1 to 10, wherein the detection circuit is integrated inside a single chip; or, components of the detection circuit, except for the processor, is integrated inside a single chip (100).

12. A method for detecting an internal resistance of a battery unit (BAT), wherein the battery unit comprises a single sub-battery, or two or more sub-batteries connected in series, between a positive terminal (VBATP) of the battery unit and the negative terminal (VBATN) of the battery unit, wherein a quantity of the sub-batteries in the battery unit is N;
wherein the method comprises:
arranging a discharge current generation circuit (10) and a first switch (SW1) in series in a branch between the positive terminal (VBATP) and the negative terminal (VBATN) of the battery unit;
controlling an operating frequency of the first switch, to allow a current disturbance to occur in the battery unit;
coupling a positive terminal of one of the at least one sub-battery to a third port, and coupling a fourth port to a negative terminal of the one of the at least one sub-battery; based on the current disturbance, converting a difference between a voltage at the third port and a reference voltage into a first digital signal through a first analog-to-digital converter;
in accordance with the first digital signal, and the discharge current (I1) or a second digital signal converted from a current sampling signal of the discharge current, obtaining an internal resistance of the sub-battery coupled between the third port and the fourth port; or, sending the first digital signal, and the discharge current signal or the second digital signal converted from the current sampling signal of the discharge current, to a processor which is configured to process the signals to obtain the internal resistance of the sub-battery coupled between the third port and the fourth port.

13. The method according to claim 12, wherein
the current sampling signal is obtained by sampling the discharge current, and is converted into the second digital signal by the first analog-to-digital converter.

14. The method according to claim 12, wherein the reference voltage is obtained by conversion through a digital-to-analog converter, which is used to convert a received digital signal into the reference voltage, the received digital signal is either a digital signal output by the logic control circuit, or a digital signal converted by the first analog-to-digital converter from a maximum voltage at the third port when the first switch is operated in off state; and/or
wherein when the logic control circuit controls the first switch to operate at a predetermined frequency, the reference voltage is an average value of a voltage at the third port.

15. The method according to claim 12, wherein when N is greater than 1, positive and negative terminals of the N sub-batteries are coupled to a multiplexer; the multiplexer is used to select and couple a positive terminal of an i-th sub-battery of the N sub-batteries with the third port in a time-sharing manner, and to couple a negative terminal of the i-th sub-battery with the fourth port, where 1≤i≤N.

## Patentansprüche

1. Detektionsschaltung zum Detektieren eines Innenwiderstands einer Batterieeinheit (BAT), wobei die Batterieeinheit eine einzelne Teilbatterie oder zwei oder mehr in Reihe geschaltete Teilbatterien zwischen einem positiven Anschluss (VBATP) der Batterieeinheit und einem negativen Anschluss (VBATN) der Batterieeinheit umfasst, wobei eine Anzahl der Teilbatterien in der Batterieeinheit N beträgt;
wobei die Detektionsschaltung Folgendes umfasst:
erste bis vierte Ports, wobei der positive Anschluss (VBATP) der Batterieeinheit mit dem ersten Port gekoppelt und der negative Anschluss (VBATN) der Batterieeinheit mit dem zweiten Port gekoppelt ist, wobei der dritte Port mit einem positiven Anschluss einer der mindestens einen Teilbatterien gekoppelt und der vierte Port mit einem negativen Anschluss der einen der mindestens einen Teilbatterien gekoppelt ist; eine Entladestrom-Erzeugungsschaltung (10) und einen ersten Schalter (SW1), wobei die Entladestrom-Erzeugungsschaltung und der erste Schalter in einem Zweig zwischen dem ersten Port und dem zweiten Port in Reihe angeordnet sind, wobei die Entladestrom-Erzeugungsschaltung dazu verwendet wird, einen Entladestrom (I1) zu erzeugen, und wobei durch Steuern einer Betätigungsfrequenz des ersten Schalters eine Stromstörung in der Batterieeinheit hervorgerufen wird;
einen ersten Analog-Digital-Wandler, der basierend auf der Stromstörung eine Differenz zwischen einer Spannung am dritten Port und einer Referenzspannung in ein erstes Digitalsignal umwandelt, wobei die Referenzspannung von einer Referenzspannungs-Erzeugungsschaltung (30) erzeugt wird; eine Logiksteuerschaltung, wobei die Logiksteuerschaltung dazu eingerichtet ist, die Betätigungsfrequenz des ersten Schalters zu steuern und einen Innenwiderstand der zwischen dem dritten Port und dem vierten Port gekoppelten Teilbatterie anhand des ersten Digitalsignals sowie des Entladestroms oder eines aus einem Stromabtastsignal des Entladestroms umgewandelten zweiten Digitalsignals zu ermitteln, oder wobei die Logiksteuerschaltung dazu eingerichtet ist, das erste Digitalsignal sowie das Entladestromsignal oder das aus dem Stromabtastsignal des Entladestroms umgewandelte zweite Digitalsignal an einen Prozessor zu senden, der dazu eingerichtet ist, die Signale zu verarbeiten, um den Innenwiderstand der zwischen dem dritten Port und dem vierten Port gekoppelten Teilbatterie zu ermitteln.

2. Detektionsschaltung nach Anspruch 1, ferner umfassend eine Stromabtastschaltung (20), die dazu eingerichtet ist, den Entladestrom abzutasten, um das Stromabtastsignal zu erhalten, wobei der erste Analog-Digital-Wandler ferner dazu verwendet wird, das Stromabtastsignal in das zweite Digitalsignal umzuwandeln.

3. Detektionsschaltung nach Anspruch 1, wobei die Referenzspannungs-Erzeugungsschaltung ein Digital-Analog-Wandler ist, der dazu verwendet wird, ein empfangenes Digitalsignal in die Referenzspannung umzuwandeln.

4. Detektionsschaltung nach Anspruch 3, wobei das empfangene Digitalsignal entweder ein von der Logiksteuerschaltung ausgegebenes Digitalsignal oder ein Digitalsignal ist, das von dem ersten Analog-Digital-Wandler aus einer am dritten Port detektierten Maximalspannung umgewandelt wird, wenn der erste Schalter im ausgeschalteten Zustand betrieben wird.

5. Detektionsschaltung nach Anspruch 1, wobei die Referenzspannung ein Mittelwert einer Spannung am dritten Port ist, wenn die Logiksteuerschaltung den ersten Schalter zum Betrieb mit einer vorbestimmten Frequenz steuert.

6. Detektionsschaltung nach Anspruch 5, wobei die Referenzspannungs-Erzeugungsschaltung einen zweiten Analog-Digital-Wandler und einen Digital-Analog-Wandler umfasst; wobei ein Eingangsanschluss des zweiten Analog-Digital-Wandlers mit dem dritten Port gekoppelt ist,
wobei wenn die Logiksteuerschaltung den ersten Schalter zum Betrieb mit einer vorbestimmten Frequenz steuert:
der zweite Analog-Digital-Wandler eine Analog-Digital-Umwandlung und eine Mittelwertbildung für die Spannung am dritten Port in mindestens einem aufeinanderfolgenden Schaltzyklus durchführt und anschließend ein drittes Digitalsignal ausgibt; oder
der zweite Analog-Digital-Wandler jedes Mal ein drittes Digitalsignal ausgibt, wenn eine Zeitsteuerung eine vorbestimmte Zeitsteuerperiode erreicht, wobei der zweite Analog-Digital-Wandler eine Analog-Digital-Umwandlung und eine Mittelwertbildung für die Spannung am dritten Port innerhalb der vorbestimmten Zeitsteuerperiode durchführt und anschließend das dritte Digitalsignal ausgibt; und
wobei der Digital-Analog-Wandler dazu eingerichtet ist, das dritte Digitalsignal in die Referenzspannung umzuwandeln.

7. Detektionsschaltung nach Anspruch 1, ferner umfassend einen zweiten Schalter (SW2) und einen dritten Schalter (SW3),
wobei der zweite Schalter in einem Zweig zwischen der Referenzspannungs-Erzeugungsschaltung und dem ersten Analog-Digital-Wandler gekoppelt ist, wobei der dritte Schalter in einem Zweig zwischen dem dritten Port und dem ersten Analog-Digital-Wandler gekoppelt ist, wobei die Logiksteuerschaltung dazu eingerichtet ist, Ein- und Aus-Zustände des zweiten Schalters und des dritten Schalters zu steuern;
wobei beim Betrieb des zweiten Schalters und des dritten Schalters in dem Einschaltzustand der erste Analog-Digital-Wandler die Differenz zwischen der Spannung am dritten Port und der Referenzspannung in das erste Digitalsignal umwandelt.

8. Detektionsschaltung nach Anspruch 2, wobei
die Stromabtastschaltung ein Widerstand (R1) ist, der in einem Zweig, in dem sich die Entladestrom-Erzeugungsschaltung befindet, in Reihe geschaltet ist; wobei das Stromabtastsignal anhand einer Spannung über dem Widerstand ermittelt wird,
wobei die Detektionsschaltung ferner einen vierten Schalter (SW4) und einen fünften Schalter (SW5) umfasst; wobei der vierte Schalter in einem Zweig zwischen einem ersten Ende des Widerstands und dem ersten Analog-Digital-Wandler gekoppelt ist, wobei der fünfte Schalter in einem Zweig zwischen einem zweiten Ende des Widerstands und dem ersten Analog-Digital-Wandler gekoppelt ist, wobei die Logiksteuerschaltung dazu eingerichtet ist, Ein- und Aus-Zustände des vierten Schalters und des fünften Schalters zu steuern,
wobei beim Betrieb des vierten Schalters und des fünften Schalters in dem Einschaltzustand der erste Analog-Digital-Wandler das Stromabtastsignal in das zweite Digitalsignal umwandelt.

9. Detektionsschaltung nach Anspruch 1, wobei
wenn N größer als 1 ist, die Detektionsschaltung ferner einen Multiplexer umfasst, der mit positiven und negativen Anschlüssen der N Teilbatterien gekoppelt ist, wobei der Multiplexer dazu verwendet wird, einen positiven Anschluss einer i-ten Teilbatterie der N Teilbatterien im Time-Sharing-Verfahren auszuwählen und mit dem dritten Port zu koppeln sowie einen negativen Anschluss der i-ten Teilbatterie mit dem vierten Port zu koppeln, wobei 1 ≤ i ≤ N gilt.

10. Detektionsschaltung nach Anspruch 1, wobei die Spannung über der zwischen dem dritten Port und dem vierten Port gekoppelten Teilbatterie unter Anwendung einer Kelvin-Verbindungsmethode ermittelt wird.

11. Detektionsschaltung nach einem der Ansprüche 1 bis 10, wobei die Detektionsschaltung innerhalb eines einzelnen Chips integriert ist, oder wobei Komponenten der Detektionsschaltung mit Ausnahme des Prozessors innerhalb eines einzelnen Chips (100) integriert sind.

12. Verfahren zum Detektieren eines Innenwiderstands einer Batterieeinheit (BAT), wobei die Batterieeinheit eine einzelne Teilbatterie oder zwei oder mehr in Reihe geschaltete Teilbatterien zwischen einem positiven Anschluss (VBATP) der Batterieeinheit und einem negativen Anschluss (VBATN) der Batterieeinheit umfasst, wobei eine Anzahl der Teilbatterien in der Batterieeinheit N beträgt;
wobei das Verfahren Folgendes umfasst:
Anordnen einer Entladestrom-Erzeugungsschaltung (10) und eines ersten Schalters (SW1) in Reihe in einem Zweig zwischen dem positiven Anschluss (VBATP) und dem negativen Anschluss (VBATN) der Batterieeinheit;
Steuern einer Betätigungsfrequenz des ersten Schalters, um eine Stromstörung in der Batterieeinheit auftreten zu lassen;
Koppeln eines positiven Anschlusses einer der mindestens einen Teilbatterien mit einem dritten Port und Koppeln eines vierten Ports mit einem negativen Anschluss der einen der mindestens einen Teilbatterien; Umwandeln einer Differenz zwischen einer Spannung am dritten Port und einer Referenzspannung durch einen ersten Analog-Digital-Wandler in ein erstes Digitalsignal basierend auf der Stromstörung;
Ermitteln eines Innenwiderstands der zwischen dem dritten Port und dem vierten Port gekoppelten Teilbatterie anhand des ersten Digitalsignals sowie des Entladestroms (I1) oder eines aus einem Stromabtastsignal des Entladestroms umgewandelten zweiten Digitalsignals; oder Senden des ersten Digitalsignals sowie des Entladestromsignals oder des aus dem Stromabtastsignal des Entladestroms umgewandelten zweiten Digitalsignals an einen Prozessor, der dazu eingerichtet ist, die Signale zu verarbeiten, um den Innenwiderstand der zwischen dem dritten Port und dem vierten Port gekoppelten Teilbatterie zu ermitteln.

13. Verfahren nach Anspruch 12, wobei
das Stromabtastsignal durch Abtasten des Entladestroms ermittelt und durch den ersten Analog-Digital-Wandler in das zweite Digitalsignal umgewandelt wird.

14. Verfahren nach Anspruch 12, wobei die Referenzspannung durch Umwandlung mittels eines Digital-Analog-Wandlers ermittelt wird, der dazu verwendet wird, ein empfangenes Digitalsignal in die Referenzspannung umzuwandeln, wobei das empfangene Digitalsignal entweder ein von der Logiksteuerschaltung ausgegebenes Digitalsignal oder ein Digitalsignal ist, das von dem ersten Analog-Digital-Wandler aus einer Maximalspannung am dritten Port umgewandelt wird, wenn der erste Schalter im ausgeschalteten Zustand betrieben wird; und/oder
wobei die Referenzspannung ein Mittelwert einer Spannung am dritten Port ist, wenn die Logiksteuerschaltung den ersten Schalter zum Betrieb mit einer vorbestimmten Frequenz steuert.

15. Verfahren nach Anspruch 12, wobei wenn N größer als 1 ist, positive und negative Anschlüsse der N Teilbatterien mit einem Multiplexer gekoppelt werden, wobei der Multiplexer dazu verwendet wird, einen positiven Anschluss einer i-ten Teilbatterie der N Teilbatterien im Time-Sharing-Verfahren auszuwählen und mit dem dritten Port zu koppeln sowie einen negativen Anschluss der i-ten Teilbatterie mit dem vierten Port zu koppeln, wobei 1 ≤ i ≤ N gilt.

## Revendications

1. Circuit de détection destiné à détecter une résistance interne d'une unité de batterie (BAT), dans lequel l'unité de batterie comprend une seule sous-batterie, ou deux ou plusieurs sous-batteries connectées en série, entre une borne positive (VBATP) de l'unité de batterie et une borne négative (VBATN) de l'unité de batterie, dans lequel le nombre de sous-batteries dans l'unité de batterie est égal à N ;
dans lequel le circuit de détection comprend :
des premier à quatrième ports, dans lequel la borne positive (VBATP) de l'unité de batterie est couplée au premier port, et la borne négative (VBATN) de l'unité de batterie est couplée au deuxième port, le troisième port est couplé à une borne positive de l'une de l'au moins une sous-batterie, et le quatrième port est couplé à une borne négative de l'une de l'au moins une sous-batterie ; un circuit de génération de courant de décharge (10) et un premier commutateur (SW1), dans lequel le circuit de génération de courant de décharge et le premier commutateur sont disposés en série dans une branche entre le premier port et le deuxième port, le circuit de génération de courant de décharge est utilisé pour générer un courant de décharge (I1), et en commandant une fréquence de fonctionnement du premier commutateur, une perturbation de courant se produit dans l'unité de batterie ;
un premier convertisseur analogique-numérique qui, sur la base de la perturbation de courant, convertit une différence entre une tension au niveau du troisième port et une tension de référence en un premier signal numérique, la tension de référence étant générée par un circuit de génération de tension de référence (30) ; un circuit de commande logique, dans lequel le circuit de commande logique est configuré pour commander la fréquence de fonctionnement du premier commutateur et pour obtenir une résistance interne de la sous-batterie couplée entre le troisième port et le quatrième port en fonction du premier signal numérique, et du courant de décharge ou d'un deuxième signal numérique converti à partir d'un signal d'échantillonnage de courant du courant de décharge ; ou, le circuit de commande logique est configuré pour envoyer le premier signal numérique, et le signal de courant de décharge ou le deuxième signal numérique converti à partir du signal d'échantillonnage de courant du courant de décharge, à un processeur qui est configuré pour traiter les signaux afin d'obtenir la résistance interne de la sous-batterie couplée entre le troisième port et le quatrième port.

2. Circuit de détection selon la revendication 1, comprenant en outre un circuit d'échantillonnage de courant (20), configuré pour échantillonner le courant de décharge afin d'obtenir le signal d'échantillonnage de courant, et le premier convertisseur analogique-numérique est en outre utilisé pour convertir le signal d'échantillonnage de courant en un deuxième signal numérique.

3. Circuit de détection selon la revendication 1, dans lequel le circuit de génération de tension de référence est un convertisseur numérique-analogique, qui est utilisé pour convertir un signal numérique reçu en tension de référence.

4. Circuit de détection selon la revendication 3, dans lequel le signal numérique reçu est soit un signal numérique délivré en sortie par le circuit de commande logique, soit un signal numérique qui est converti par le premier convertisseur analogique-numérique à partir d'une tension maximale détectée au niveau du troisième port lorsque le premier commutateur fonctionne dans un état désactivé.

5. Circuit de détection selon la revendication 1, dans lequel, lorsque le circuit de commande logique commande le premier commutateur pour qu'il fonctionne à une fréquence prédéterminée, la tension de référence est une valeur moyenne d'une tension au niveau du troisième port.

6. Circuit de détection selon la revendication 5, dans lequel le circuit de génération de tension de référence comprend un deuxième convertisseur analogique-numérique et un convertisseur numérique-analogique ; une borne d'entrée du deuxième convertisseur analogique-numérique est couplée au troisième port,
dans lequel, lorsque le circuit de commande logique commande le premier commutateur pour qu'il fonctionne à la fréquence prédéterminée :
le deuxième convertisseur analogique-numérique effectue une conversion analogique-numérique et une opération de moyennage sur la tension au niveau du troisième port au cours d'au moins un cycle de commutation consécutif, puis délivre en sortie un troisième signal numérique ; ou
le deuxième convertisseur analogique-numérique délivre en sortie un troisième signal numérique chaque fois qu'un minutage atteint une période de temps prédéterminée, dans lequel le deuxième convertisseur analogique-numérique effectue une conversion analogique-numérique et une opération de moyennage sur la tension au niveau du troisième port au sein de la période de temps prédéterminée, puis délivre en sortie le troisième signal numérique ; et
le convertisseur numérique-analogique est configuré pour convertir le troisième signal numérique en tension de référence.

7. Circuit de détection selon la revendication 1, comprenant en outre un deuxième commutateur (SW2) et un troisième commutateur (SW3),
dans lequel le deuxième commutateur est couplé dans une branche entre le circuit de génération de tension de référence et le premier convertisseur analogique-numérique ; le troisième commutateur est couplé dans une branche entre le troisième port et le premier convertisseur analogique-numérique ; le circuit de commande logique est configuré pour commander des états activé et désactivé du deuxième commutateur et du troisième commutateur ;
dans lequel, lorsque le deuxième commutateur et le troisième commutateur fonctionnent dans un état activé, le premier convertisseur analogique-numérique convertit la différence entre la tension au niveau du troisième port et la tension de référence en un premier signal numérique.

8. Circuit de détection selon la revendication 2, dans lequel :
le circuit d'échantillonnage de courant est une résistance (R1), qui est connectée en série dans une branche où se trouve le circuit de génération de courant de décharge ; le signal d'échantillonnage de courant est obtenu en fonction d'une tension aux bornes de la résistance ;
le circuit de détection comprend en outre un quatrième commutateur (SW4) et un cinquième commutateur (SW5) ; le quatrième commutateur est couplé dans une branche entre une première extrémité de la résistance et le premier convertisseur analogique-numérique ; le cinquième commutateur est couplé dans une branche entre une seconde extrémité de la résistance et le premier convertisseur analogique-numérique ; le circuit de commande logique est configuré pour commander des états activé et désactivé du quatrième commutateur et du cinquième commutateur ;
lorsque le quatrième commutateur et le cinquième commutateur fonctionnent dans un état activé, le premier convertisseur analogique-numérique convertit le signal d'échantillonnage de courant en un deuxième signal numérique.

9. Circuit de détection selon la revendication 1, dans lequel,
lorsque N est supérieur à 1, le circuit de détection comprend en outre un multiplexeur, qui est couplé à des bornes positives et négatives des N sous-batteries ; le multiplexeur est utilisé pour sélectionner et coupler une borne positive d'une i-ième sous-batterie parmi les N sous-batteries au troisième port selon un mode de partage de temps, et pour coupler une borne négative de la i-ième sous-batterie au quatrième port, dans lequel 1 ≤ i ≤ N.

10. Circuit de détection selon la revendication 1, dans lequel la tension aux bornes de la sous-batterie couplée entre le troisième port et le quatrième port est obtenue à l'aide d'une méthode de connexion Kelvin.

11. Circuit de détection selon l'une quelconque des revendications 1 à 10, dans lequel le circuit de détection est intégré à l'intérieur d'une seule puce ; ou, des composants du circuit de détection, à l'exception du processeur, sont intégrés à l'intérieur d'une seule puce (100).

12. Procédé de détection destiné à détecter une résistance interne d'une unité de batterie (BAT), dans lequel l'unité de batterie comprend une seule sous-batterie, ou deux ou plusieurs sous-batteries connectées en série, entre une borne positive (VBATP) de l'unité de batterie et une borne négative (VBATN) de l'unité de batterie, dans lequel le nombre de sous-batteries dans l'unité de batterie est égal à N ;
dans lequel le procédé comprend :
la disposition d'un circuit de génération de courant de décharge (10) et d'un premier commutateur (SW1) en série dans une branche entre la borne positive (VBATP) et la borne négative (VBATN) de l'unité de batterie ;
la commande d'une fréquence de fonctionnement du premier commutateur, afin de permettre l'apparition d'une perturbation de courant dans l'unité de batterie ;
le couplage d'une borne positive de l'une de l'au moins une sous-batterie à un troisième port, et le couplage d'un quatrième port à une borne négative de l'une de l'au moins une sous-batterie ; sur la base de la perturbation de courant, la conversion d'une différence entre une tension au niveau du troisième port et une tension de référence en un premier signal numérique via un premier convertisseur analogique-numérique ;
en fonction du premier signal numérique, et du courant de décharge (I1) ou d'un deuxième signal numérique converti à partir d'un signal d'échantillonnage de courant du courant de décharge, l'obtention d'une résistance interne de la sous-batterie couplée entre le troisième port et le quatrième port ; ou, l'envoi du premier signal numérique, du signal de courant de décharge ou du deuxième signal numérique converti à partir du signal d'échantillonnage de courant du courant de décharge, à un processeur qui est configuré pour traiter les signaux afin d'obtenir la résistance interne de la sous-batterie couplée entre le troisième port et le quatrième port.

13. Procédé selon la revendication 12, dans lequel
le signal d'échantillonnage de courant est obtenu par échantillonnage du courant de décharge, et est converti en un deuxième signal numérique par le premier convertisseur analogique-numérique.

14. Procédé selon la revendication 12, dans lequel la tension de référence est obtenue par conversion via un convertisseur numérique-analogique, qui est utilisé pour convertir un signal numérique reçu en tension de référence, le signal numérique reçu est soit un signal numérique délivré en sortie par le circuit de commande logique, soit un signal numérique converti par le premier convertisseur analogique-numérique à partir d'une tension maximale au niveau du troisième port lorsque le premier commutateur fonctionne dans un état désactivé ; et/ou
dans lequel, lorsque le circuit de commande logique commande le premier commutateur pour qu'il fonctionne à une fréquence prédéterminée, la tension de référence est une valeur moyenne d'une tension au niveau du troisième port.

15. Procédé selon la revendication 12, dans lequel, lorsque N est supérieur à 1, des bornes positives et négatives des N sous-batteries sont couplées à un multiplexeur ; le multiplexeur est utilisé pour sélectionner et coupler une borne positive d'une i-ième sous-batterie parmi les N sous-batteries au troisième port selon un mode de partage de temps, et pour coupler une borne négative de la i-ième sous-batterie au quatrième port, dans lequel 1 ≤ i ≤ N.
